# EUROPEAN PATENT APPLICATION

(11) **EP 2 730 892 A1**
(43) Date of publication of application: **14.05.2014**
(21) Application number: 12192122.5
(22) Date of filing: 09.11.2012
(51) Int. Cl.: G01D 5/241, G01D 3/08, H03K 17/975, G01L 1/14

(54) **Capacitive sensor element, use of such capacitive sensor element and electrical appliance comprising such capacitive sensor element**

(71) Applicant: Clicktouch, 9890 Gavere (BE)
(72) Inventor: Demets, Luc, B-9890 Gavere (BE)
(74) Representative: Duyver, Jurgen Martha Herman

(57) **Abstract**

Capacitive sensor element (1) for electrical appliances, the capacitive sensor element (1) comprising a capacitor (2) with a first electrically conductive sensor surface (3), at least one second electrically conductive sensor surface (4) adjacent to and opposing the first sensor surface (3) and a dielectric layer (5) in between the first and the second conductive surface (3, 4) and capacitance measuring means (6) for measuring the capacitance of the capacitor (2), the first sensor surface (3) being provided to be pressed such that by pressure the first sensor surface (3) approaches at least partly the second sensor surface (4) resulting in a change in capacitance measured by the capacitance measuring means (6), **characterized in that** the first electrically conductive sensor surface (3) comprises an electrical insulation layer (7) on a side of the first electrically conductive sensor surface (3) facing away from the second electrically conductive sensor surface (4).

## Description

The current invention relates to a capacitive sensor element according to the preamble of the first claim.

The present invention also relates to the use of such capacitive sensor element and an electrical appliance comprising such capacitive sensor element.

Such capacitive sensor elements are already known to the person skilled in the art. WO2005067146A1 for example describes a capacitive sensor element for electrical appliances. The capacitive sensor element comprises a capacitor with a first electrically conductive sensor surface, a second electrically conductive sensor surface adjacent to and opposing the first sensor surface and a dielectric layer in between the first and the second conductive surface. Further capacitance measuring means for measuring the capacitance of the capacitor are provided. The first sensor surface is provided to be pressed and is shape-variable or elastic such that by pressure the first sensor surface approaches at least partly the second sensor surface resulting in a change in capacitance measured by the capacitance measuring means. The first sensor surface is provided to be directly contacted by a user and is electrically conductive throughout and in particular is formed from a single material layer. The first sensor surface may be grounded or not.

However, in such configuration, when the first sensor surface, if ungrounded, comes into contact with a relatively high differential voltage, the electronics, such as for example the capacitance measuring means, connected to the second sensor surface, or even the second sensor surface itself, may become damaged. Moreover, when for example multiple separate second sensor surfaces are provided in such situation the capacitance measuring means would detect a similar change in capacitance as the differential voltage spreads over the first sensor surface upon contact. Moreover, the first sensor surface would interact with different kinds of electromagnetic radiation such that the capacitive sensor element would exhibit a relative bad electro-magnetic compatibility (EMC).

Although WO2005067146A1 suggests to ground the first sensor surface such configuration has also been found to nevertheless have an insufficient electro-magnetic compatibility (EMC). Moreover, such configuration is not applicable in portable electronic appliances as such appliances can not, or at least not easily, be grounded.

In addition, often safety regulations, for example for white goods, require that there must be at least a single and sometimes even a double galvanic insulation between a user and the electronics of the device, which is for example not the case should the dielectric layer be, for example, air.

Therefore, it is an object of the current invention to provide a capacitive sensor element which is safer.

This is achieved with a capacitive sensor element according to the characterizing part of the first claim.

Thereto, the first electrically conductive sensor surface comprises an electrical insulation layer on a side of the first electrically conductive sensor surface facing away from the second electrically conductive sensor surface.

It has been found that such electrical insulation layer substantially covering, preferably fully covering, the first sensor surface allows shielding users from the electronics such that a safer configuration is obtained. Moreover, it has been found that the presence of the electrical insulation layer does not substantially deteriorate the measured change in capacitance such that the working of the sensor is not substantially deteriorated.

Moreover, it has been found that such configuration prevents that the first sensor surface comes into contact with high differential voltages avoiding damage to the second sensor surface and/or further electronics. Further, the electrical insulation layer prevents that differential voltages spread over the first sensor surface such that unwanted changes in capacitance are being measured by the capacitance measuring means.

It has also been found that the capacitive sensor element according to the present invention can also be used by a person wearing, for example, non-electrically conducting gloves, such as for example plastic gloves, such as for example in a lab environment or other environments were the wearing of gloves is usual or even mandatory, as the capacitive sensor element according to the present invention measures changes in capacitance due to a spatial change of the configuration of the first sensor surface with respect to the second sensor surface and less, or even not, due to contact of a conducting element, such as for example a finger of the user, with the first sensor surface.

In addition, due to the presence of the electrical insulation layer, the electrical properties of the surface provided to be contacted by a user can be chosen independently from the desired properties such as smoothness, strength, thickness, etc. This for example has as a consequence that the total thickness of the capacitive sensor element can be reduced to about for example 600 micron thick.

According to preferred embodiments of the current invention, the dielectric material of the dielectric layer is air as it cheap and readily available, although other dielectric materials known to the person skilled in the art are possible depending on the desired application.

According to preferred embodiments of the current invention, at least two second sensor surfaces are provided. This way, movement of for example a finger of a user can be determined such that sliding motions, , can be monitored and interpreted. This way it becomes possible to provide the second sensor surfaces one-dimensionally next to each other, for example to provide a longitudinal or circular so-called slider, or in a two-dimensional array to, for example, provide a so-called touchpad or even touch screen. It has been found that especially in such configurations a relative precise and accurate measurement of the capacitance and change of capacitance due to a touch by a user is required.

According to preferred embodiments of the current invention, the first sensor surface is shape-variable or elastic such that by pressing the first sensor surface, the first sensor surface deforms such that at least part of the first sensor surface approaches the second sensor surface resulting in a change in capacitance that can be measured by the capacitance measuring means.

According to preferred embodiments of the current invention, the first electrically conductive sensor surface is electrically connected to the potential reference level of the capacitance measuring means, preferably the 0V of the electronics in the capacitive sensor element, especially the capacitance measuring means, especially when the capacitive sensor element is provided to a portable electrical appliance. This way, for example, the electro-magnetic compatibility is improved, especially when being connected to the 0V of the electronics in the capacitive sensor element, especially capacitance measuring means, as the first sensor surface is kept at the substantially same potential reference level. The presence of the electrical insulation layer prevents the occurrence of electrostatic discharges to, for example, the capacitance measuring means, comprising often electronics, with for example the ability of damaging the electronics, which could occur when omitting the electrical insulation layer.

Moreover, when the first electrically conductive sensor surface is electrically connected to the 0V of the electronics in the capacitive sensor element, especially the capacitance measuring means, it has been found that the capacitance measuring means can be provided such that even the degree of pressure applied by the user to the first sensor surface can be taken into account as the change of capacitance measured by the capacitance measuring means can be measured more precisely such that the degree of change of the measured capacitance can be related to the degree of applied pressure. This way, for example, a light touch of the capacitive sensor element, more precisely the first sensor surface, by a user can be related to a first signal and a more firm touch of the capacitive sensor element, more precisely the first sensor surface, can be related to a second signal.

According to other preferred embodiments of the current invention, also additional parameters relating to the input of the user can be taken into account such as the number of pushes applied by the user, the speed with which the different pushes are applied by the user, etc.

According to preferred embodiments of the current invention, at least part of the circuitry interconnecting the first sensor surface to the capacitance measuring means is provided along and adjacent to the insulation layer. In such configuration it has been found that the circuitry interconnecting the first sensor surface to the capacitance measuring means provided along and adjacent to the insulation layer forms a layer shielding electronics below it from electro-magnetic influence.

According to preferred embodiments of the current invention, the circuitry, if present, and/or the first sensor surface is printed, preferably silk-screen printed, on the insulation layer, preferably with a conductive ink, such as for example silver (Ag) based inks. By printing, the thickness and/or weight of the capacitive sensor element can be further reduced which is often desired, especially when the capacitive sensor element is intended to be used in portable electrical appliances. For example, a thickness for the insulation layer of about 125 micron, for example when the insulation layer is a PET sheet, and a thickness of 15 micron for the ink, for example when the ink is a silver ink, have been found possible.

According to preferred embodiments of the current invention, the electrical insulation layer for example comprises or even is a PET sheet, especially when the circuitry, if present, and/or the first sensor surface is printed, preferably silk-screen printed, on the insulation layer, preferably with a conductive ink, such as for example silver (Ag) based inks.

According to preferred embodiments of the current invention, the circuitry is provided on the side of the electrical insulation layer facing the second sensor surface. In such configuration, the electrical insulation layer further shields a user from electronics.

According to preferred embodiments of the current invention, the dielectric layer comprises at least two layers. In such configuration one of the layers can be provided especially for its dielectric properties whereas the other layer can be provided for its specific electrical insulation properties. It has been found that an additional electrical insulation layer can prevent the first sensor surface from electrically contacting the second sensor surface, for example when the dielectric layer comprises air. For example, an additional electrical insulation layer can be printed on top of the circuitry, if present, and/or over the first sensor surface. Such layer can especially be desired if safety regulations require so, for example with certain white goods. However, as an alternative to printing other techniques can be employed for applying the additional electrical insulation layer, for example a compressible rubber sheet. The additional electrical insulation can for example have a thickness of about 30 microns.

According to preferred embodiments of the current invention, the sensor element comprises a first and/or a second adhesive layer along the first and/or the second sensor surface respectively. Such adhesive layers have been found to further electrically insulate the first and second sensor surface and/or the circuitry of the capacitive sensor element.

According to preferred embodiments of the current invention, a front panel is provided along the first sensor surface and/or a back panel is provided along the second sensor surface. The front and/or back panel, if present, have been found to provide structural strength to the capacitive sensor element if desired. The front panel must be able to deflect such as to be able to transmit pressure and deformation to the first sensor surface. It has been found that a few microns may be sufficient. It further has been found that due to the presence of the insulation layer, the electrical properties of the front panel have little or even no impact on the working of the sensor element, except when safety regulations for example require that a plurality of insulation layers are present between a user and the electronics of a device in which case the front and/or black plate preferably are substantially electronic isolators. Successful tests have been performed using for example a polycarbonate front panel with a thickness of about 3mm, a glass front panel with a thickness of about 1 mm and a aluminum front panel with a thickness of about 2mm.

According to more preferred embodiments of the current invention, the front panel, if present, is adhered to the first sensor surface with the first adhesive layer and/or the back panel, if present, is adhered to the second sensor surface with the second adhesive layer.

According to preferred embodiments of the present invention, the first sensor surface and the second sensor surface are spaced from each other by a spacer layer, for example an adhesive, for example having a thickness of about 225 micron. Although the spacer layer may, at least partly form the dielectric material, this is not critical for the invention, for example when the dielectric layer comprises air as dielectric material. The spacer layer can be in the form of, for example, die cut material, for example adhesive, with holes provided where the sensor surfaces are provided.

The invention also relates to the use of capacitive sensor element according to the invention for operating an electrical appliance.

The invention also relates to an electrical appliance comprising the capacitive sensor element according to the invention.

According to preferred embodiments of the electrical appliance according to the invention, the electrical appliance is a domestic appliance such as for example white goods.

The invention will be further elucidated by means of the following description and the appended figures.

Figure 1 shows a cross section of a preferred embodiment of a capacitive sensor element according to the invention.

Figure 2a, Figure 2b, Figure 2c and Figure 2d show an exploded view of different embodiments of the capacitive sensor element according to invention.
1. capacitive sensor element
2. capacitor
3. first electrically conductive surface
4. second electrically conductive surface
5. dielectric layer
6. capacitance measuring means
7. electrical insulation layer
8. circuitry
9. first adhesive layer
10. second adhesive layer
11. front panel
12. back panel
13. spacer material

In the following detailed description, numerous specific details are set forth in order to provide a thorough understanding of the invention and how it may be practiced in particular embodiments. However, it will be understood that the present invention may be practiced without these specific details. In other instances, well-known methods, procedures and techniques have not been described in detail, so as not to obscure the present invention. While the present invention will be described with respect to particular embodiments and with reference to certain drawings, the invention is not limited hereto. The drawings included and described herein are schematic and are not limiting the scope of the invention. It is also noted that in the drawings, the size of some elements may be exaggerated and, therefore, not drawn to scale for illustrative purposes.

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

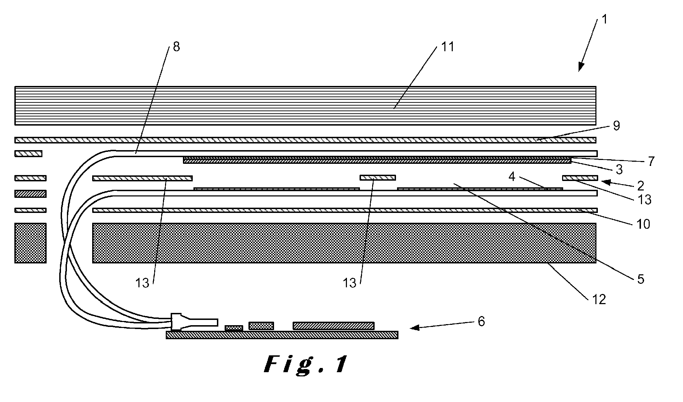

Figure 1 shows a cross section of a preferred embodiment of the capacitive sensor element according to the invention.

The capacitive sensor element 1 for electrical appliances, comprises a capacitor 2. The capacitor 2 comprises a first electrically conductive sensor surface 3, at least one second electrically conductive sensor surface 4 adjacent to and opposing the first sensor surface 3 and a dielectric layer 5 in between the first and the second conductive surface 3, 4.

The capacitive sensor element 1 further comprises capacitance measuring means 6 for measuring the capacitance of the capacitor 2. The capacitance for example depends on the distance between at least part of the first and the second sensor surfaces 3, 4. The first sensor surface 3 is provided to be pressed such that by pressure, the first sensor surface 3 approaches at least partly the second sensor surface 4 resulting in a change in capacitance measured by the capacitance measuring means 6.

The first electrically conductive sensor surface 3 comprises an electrical insulation layer 7 on a side of the first electrically conductive sensor surface 3 facing away from the second electrically conductive sensor surface 4.

Figure 1 shows that both the first as the second sensor surface 3, 4 are connected to the capacitance measuring means 6. More in particular, although not shown in the figures, the first electrically conductive sensor surface 3 preferably is electrically connected to the potential reference level of the capacitance measuring means 6.

Figure 1 shows moreover that at least part of the circuitry 8 interconnecting the first sensor surface 3 to the capacitance measuring means 6 is provided along and adjacent to the insulation layer 7.

The dielectric layer shown in figure 1 substantially comprises air. However, other dielectric materials known to the person skilled in the art may be used such as rubber or foam sheets. When using air as a dielectric material the first and the second sensor surface 3, 4 must remain spaced from each other. Thereto, figure 1 shows a layer of spacer material in between the layer comprising the first sensor surface 3 and the second sensor surface 4. The layer of spacer material 13 for example can be die cut to provide openings where the dielectric material, the air, can be provided in between the first and the second sensor surface 3, 4. However, such die cut spacer material can also be provided when using other dielectric materials. The spacer for example is 225 micron thick such the thickness of the dielectric material in between the first and the second sensor surface 3, 4 is also about 225 micron.

Figure 1 further shows that in the shown preferred embodiment of the capacitive sensor element according to the current invention, the sensor element 1 comprises a first an a second adhesive layer 9, 10 along the first and/or the second sensor surface 3, 4 respectively. Such adhesive layers are often not electrically conductive and form electrical insulators.

The first and the second adhesive layer 9, 10 shown in figure 1 are provided along a substantial part of the upper and lower surface of the capacitive sensor element 1. This is however not critical for the invention, as the adhesive layer 9, 10 can for example only be provided along a part of the respective upper and lower surface, depending on the desired adhesion of the capacitive sensor element 1, depending in its turn on, for example, the intended use of the capacitive sensor element 1. Also, only the first or the second adhesive layer 9, 10 may be provided, depending on the desired application. Preferably, however, the first and/or second adhesive layer 9, 10 are provided along a substantial part of the first and/or the second sensor surface 3, 4 such as to provide an additional electrical insulation for users using the capacitive sensor element from, for example, further circuitry of the capacitive sensor element 1 as sometimes even required by safety regulations.

The application of one or both of the first and the second adhesive layer 9, 10 also provides the possibility of packaging the capacitive sensor element with front panel or back panel, ready to be adhered to, for example, another device. In such embodiment, the capacitive sensor element 1 can be provided to existing devices as an input device and can for example be glued to the device after, for example, interconnecting the capacitance measuring means 6 to the device.

Figure 1 further shows that a front panel 11 is provided along the first sensor surface 3 and a back panel 12 is provided along the second sensor surface 4. As explained above, this is not critical for the invention but allows to further adapt to the capacitive sensor element to the intended application for the capacitive sensor element 1. For example, a front panel 11 can be provided without a back panel 12 when the capacitive sensor element 1 for example will be applied to an existing back panel 12. According to another example, a back panel 12 can be provided without a front panel 11 if it desired not to provide a front panel 11 or when the front panel 11 will be applied later, for example such as to be able to provide different front panels 11, depending on the intended use of the capacitive sensor element 1.

In general, the back panel 12 for example provides strength to the capacitive sensor element 1 for, for example, withstanding the pressure applied by a user to the capacitive sensor element 1, especially when, for example, the front panel 11, if present, is less adapted at providing sufficient strength, for example when a fragile material, such as for example a relative thin sheet of glass, is used for the front panel 11.

The front panel 11 preferably is adapted for transmitting pressure applied by a user to the capacitive sensor element 1 to the first sensor surface 3 and is provided to be contacted by the user. The front panel 11 can further, for example, be provided to be cleaned easily, to be relatively less prone to breaking, etc.

As shown in figure 1, the front panel 11 is adhered to the first sensor surface 3 with the first adhesive layer 9 and the back panel 12 is adhered to the second sensor surface 4 with the second adhesive layer 10. Such an arrangement further allows to improve the electrical insulation between the front panel and the first sensor surface 3 and even the second sensor surface 4 and a user touching the front panel 11. In addition, the second adhesive layer 10 allows to improve the electrical insulation between a user touching the capacitive sensor element 1 and the device to which it is attached. Providing both the first and the second adhesive layer 9, 10 for attaching the front panel 11 and the back panel 12 is however not critical for the invention and the front panel 11 and the back panel 12 can also be provided using other means known to the person skilled in the art.

The capacitance measuring means 6 can be any means known to the person skilled in the art for measuring the capacitance of the capacitor 2. Preferably however, the capacitance measuring means 6 comprise a Cypress Capsense® chip (http://www.cypress.com\go\capsense). The capacitance measuring means 6 preferably are provided such that the degree of pressure applied by a user to the first sensor surface 3 is taken into account by measuring the change of capacitance.

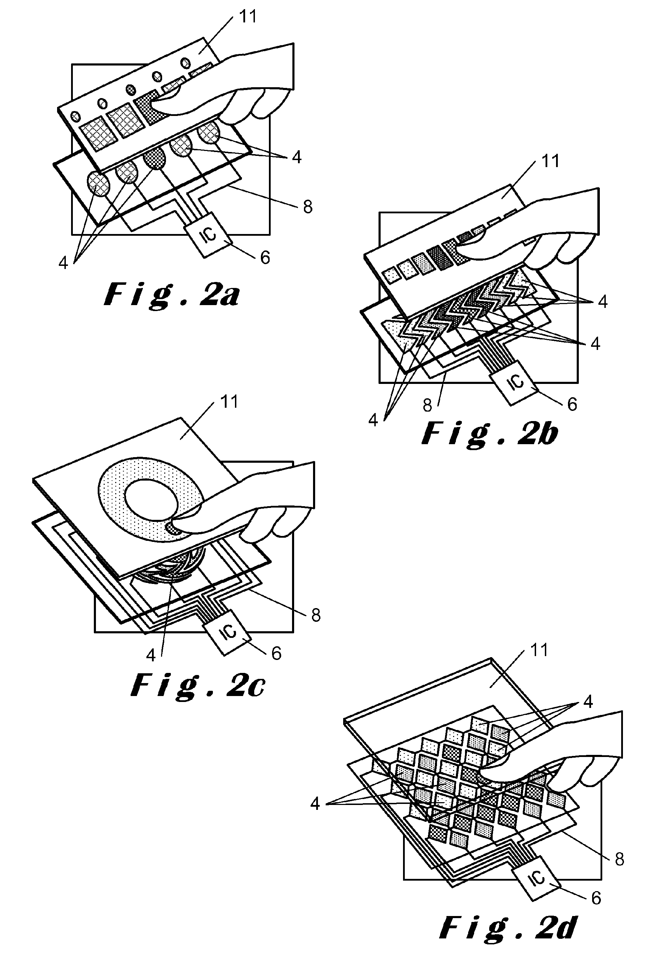

Figures 2a - 2d show some embodiments of the capacitive sensor element 1 according to the present invention comprising several second sensor surfaces 4. The different second sensor surfaces 4 can for example provide different buttons as shown in figure 2a. However according to alternative embodiments movement of for example a finger of a user can be determined such that sliding motions, of for example a finger of a user, can be monitored and interpreted. This way it becomes possible to provide the second sensor surfaces substantially one-dimensionally next to each other as for example shown in figures 2b and 2c, for example to provide a longitudinal, as shown in figure 2b, or circular, as shown in figure 2c, so-called slider, or in a two-dimensional array, as shown for example in figure 2d, to, for example, provide a so-called touchpad or even touch screen.

It has been found that especially when several second sensor surfaces are provided, the amount of circuitry interconnecting the second sensor surfaces with the capacitance measuring means 6 increases improving the shielding of electronics beneath that circuitry.

## Claims

1. Capacitive sensor element (1) for electrical appliances, the capacitive sensor element (1) comprising a capacitor (2) with a first electrically conductive sensor surface (3), at least one second electrically conductive sensor surface (4) adjacent to and opposing the first sensor surface (3) and a dielectric layer (5) in between the first and the second conductive surface (3, 4) and capacitance measuring means (6) for measuring the capacitance of the capacitor (2), the first sensor surface (3) being provided to be pressed such that by pressure the first sensor surface (3) approaches at least partly the second sensor surface (4) resulting in a change in capacitance measured by the capacitance measuring means (6), **characterized in that** the first electrically conductive sensor surface (3) comprises an electrical insulation layer (7) on a side of the first electrically conductive sensor surface (3) facing away from the second electrically conductive sensor surface (4).

2. Capacitive sensor element (1) according to claim 1, **wherein** the first electrically conductive sensor surface (3) is electrically connected to the potential reference level of the capacitance measuring means (6).

3. Capacitive sensor element (1) according to claim 2, **wherein** at least part of the circuitry (8) interconnecting the first sensor surface (3) to the capacitance measuring means (6) is provided along and adjacent to the insulation layer (7).

4. Capacitive sensor element (1) according to claim 3, **wherein** the circuitry (8) is printed, preferably silk-screen printed, on the insulation layer (7).

5. Capacitive sensor element (1) according to claim 3 or 4, **wherein** the circuitry (8) is provided on the side of the insulation layer (7) facing the second sensor surface (4).

6. Capacitive sensor element (1) according to any one of the preceding claims, **wherein** the first sensor surface (3) is printed, preferably silk-screen printed, on the insulation layer (7).

7. Capacitive sensor element (1) according to any one of the preceding claims at least in combination with claim 4 or 6, **wherein** the first sensor surface (3) and/or the circuitry (8) is printed with a conductive ink.

8. Capacitive sensor element (1) according to any one of the preceding claims, **wherein** the dielectric layer (5) comprises at least two layers.

9. Capacitive sensor element (1) according to any one of the preceding claims, **wherein** the sensor element (1) comprises a first and/or a second adhesive layer (9, 10) along the first and/or the second sensor surface (3, 4) respectively.

10. Capacitive sensor element (1) according to any one of the preceding claims, **wherein** a front panel (11) is provided along the first sensor surface (3) and/or a back panel (12) is provided along the second sensor surface (4).

11. Capacitive sensor element (1) according to claim 10 in combination with claim 9, **wherein** the front panel (11) is adhered to the first sensor surface (3) with the first adhesive layer (9) and/or the back panel (12) is adhered to the second sensor surface (4) with the second adhesive layer (10).

12. Capacitive sensor element (1) according to any one of the preceding claims, **wherein** the capacitance measuring means (6) are provided such that the degree of pressure applied by a user to the first sensor surface (3) is taken into account by measuring the change of capacitance.

13. Use of capacitive sensor element (1) according to any of the preceding claims for operating an electrical appliance.

14. Electrical appliance comprising the capacitive sensor element (1) according to any one of the preceding claims.

15. Electrical appliance according to claim 14, wherein the electrical appliance is a domestic appliance such as for example white goods.
